# EUROPEAN PATENT APPLICATION

(11) **EP 0 742 588 A2**
(43) Date of publication of application: **13.11.1996**
(21) Application number: 96303279.2
(22) Date of filing: 10.05.1996
(51) Int. Cl.: H01L 21/68

(54) **Method of protecting electrostatic chuck**

(30) Priority: 11.05.1995 US 439011
(71) Applicant: APPLIED MATERIALS, INC., Santa Clara California 95054-3299 (US); INTERNATIONAL BUSINESS MACHINES CORPORATION, Armonk, NY 10504 (US)
(72) Inventor: Salfelder, Joseph, Williston, Vermont 05495 (US); Grimard, Dennis, Williston, Vermont 05495 (US); Cameron, John F., Los Altos, CA 94022 (US); Deshpandey, Chandra, Fremont, CA 94539 (US); Ryan, Robert, Sunnyvale, California (US); Chafin, Michael G., Underhill, Vermont 05489 (US)
(74) Representative: Bayliss, Geoffrey Cyril

(57) **Abstract**

A method for enhancing the erosion resistant of an electrostatic chuck **20** for holding a substrate **45** in an erosive environment is described. The method uses an electrostatic chuck **20** comprising an electrostatic member **25** including (i) an electrode **30**, and (ii) an insulator **35** covering the electrode. The electrostatic member **25** is supported on a support **40**. A barrier **55** is positioned circumferentially about the electrostatic member **25**, the barrier **55** having a first contact surface **60** capable of being pressed against the substrate **45**. A substrate **45** is placed on the electrostatic memoer **25** so that a peripheral edge **50** of the substrate **45** contacts the contact surface **60** of the barrier. A voltage is applied to the electrostatic member **25** to electrostatically attract the substrate **45** with sufficient electrostatic force that the peripheral edge **50** of the substrate **45** presses against the contact surface **60** of the carrier **55** forming a seal between the substrate **45** and the support **40** to reduce exposure of the electrostatic member **25** to the erosive environment

## Description

The present invention is directed to method for enhancing the erosion resistance of an electrostatic chuck useful for holding and positioning substrates for processing of the substrate in an erosive process environment.

In semiconductor fabrication processes, electrostatic chucks are user to hoid substrates for processing of the substrates. Generally, an electrostatic chuck comprises an insulator covering an electrode. Typically, the insulator and electrode are supported by a support adapted to be secured in a process chamber. An electrical connector electrically connects the electrode to a voltage supply source in the process chamber. When the electrode is electrically biased with respect to the substrate held on the chuck, opposing electrostatic charge accumulates in the electrode and substrate resulting in attractive electrostatic forces that hold the substrate to the chuck. Electrostatic chucks are generally described in, for example U.S. Patent Application Serial Nos. 08/278,787 by Cameron, et al.; 08/276,735 by Shamouilian, et al.; and 08/189,562, by Shamouilian, et al. -- all of which are incorporated herein by reference.

Conventional electrostatic chucks can also have coolant grooves for holding coolant for cooling the substrate held on the chuck, for example, coolant grooves extending through the insulator as described in U.S. Patent Application No. 08/276,735 to Shamouilian, et al. When a substrate is held on the chuck, the substrate covers and seals the coolant grooves so that the coolant held in the grooves does not leak out. Cooling of the substrate reduces overheating of the substrate to provide higher yields of integrated circuit chips from the substrate.

Conventional chucks can fail or have limited lifetimes in erosive process environments. For example, when the insulator of the chuck comprises a polymeric dielectric material, such as a polyimide, the polymeric insulator can be eroded by the erosive process environment, limiting the useful lifetime of the chuck. Erosion of polymeric insulators can be particularly severe in oxygen or halogen containing gases and plasmas, which are used for a variety of tasks, such as for example, etching of substrates and cleaning of process chambers. While a large portion of the polymeric insulator is typically covered by the substrate held on the chuck and thereby protected from the erosive environment, the periphery of the insulator is exposed to, and can be eroded by the erosive gaseous environment. The exposed polymeric insulator can erode in a few hours (typically 2 to 3 hours of exposure to a oxygen plasma environment), and erosion through a single point of the insulator can expose the electrode causing short-circuiting and failure of the chuck. Failure of the chuck during processing of the substrate can damage the substrate and reduce yields of the valuable integrated circuit chips processed on the substrate. Also, the polymeric byproducts formed by the erosion of the polymer dielectric often deposit on the chuck and walls of the process chamber to form hard polymeric deposits which are difficult to clean.

Thus, it is desirable to have an method for enhancing the erosion resistance of an electrostatic chuck to reduce failure in erosive process environments. It is also desirable for the method to allow uniform cooling of the substrate held on the chuck to provide increased integrated circuit yields, particularly from the perimeter of the substrate.

The method of the present invention satisfies these needs and enhances the erosion resistant of an electrostatic chuck in an erosive environment. The method utilizes an electrostatic chuck comprising an electrostatic member capable of electrostatically holding a substrate. The electrostatic member comprises (i) an electrode, and (ii) an insulator covering the electrode. A support is used to support the electrostatic member. A barrier is positioned on the support so that the barrier is circumferentially disposed about the electrostatic member, the barrier comprising a contact surface capable of being pressed against a substrate. A substrate is placed on the electrostatic member so that a peripheral edge of the substrate contacts the contact surface of the barrier. A voltage is applied to the electrostatic member of the chuck to electrostatically attract the substrate with sufficient electrostatic force that the peripheral edge of the substrate presses against the contact surface of the barrier forming a seal between the substrate and the support to reduce exposure of the electrostatic member to the erosive environment.

In a preferred version, the barrier has a second contact surface capable of being pressed against the support so that the barrier can form a seal between the substrate and the support.

The barrier can comprise any resilient structure capable of pressing the first contact surface of the barrier against the electrostatically held substrate without dislodging the substrate. A preferred barrier structure comprises a ring having an annular lip that is capable of resiliently pressing and sealing against the peripheral edge of the substrate. Preferably, the barrier structure is fabricated from an elastomer.

These and other features, aspects, and advantages of the present invention will become better understood with regard to the following description, appended claims, and accompanying drawings which provide illustrative examples of the invention, where:
Figure 1a is a schematic partial cross-section schematic view of a process chamber showing operation of a monopolar electrostatic chuck of the present invention;
Figure 1b is a partial cross-section schematic view of a process chamber showing operation of a bipolar electrostatic chuck of the present invention:
Figure 2 is a cross-section side schematic view or a version of the chuck of the present invention, showing a barrier around the chuck;
Figure 3a is a partial cross-section side schematic view of a second version of the chuck of the present invention;
Figure 3b is a partial cross-section side schematic view of a third version of the chuck of the present invention;
Figure 3c is a partial cross-section side schematic view of a fourth version of the chuck of the present invention, showing a collar around the chuck;
Figure 3d is a partial cross-section side schematic view of a fifth version of the chuck of the present invention, showing a collar around the chuck; and

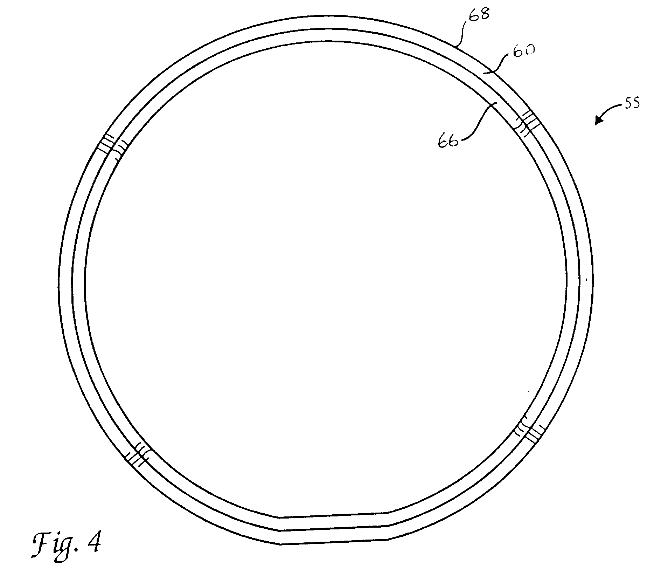

Figure 4 is a top view of the barrier of the chuck shown in Figure 2.

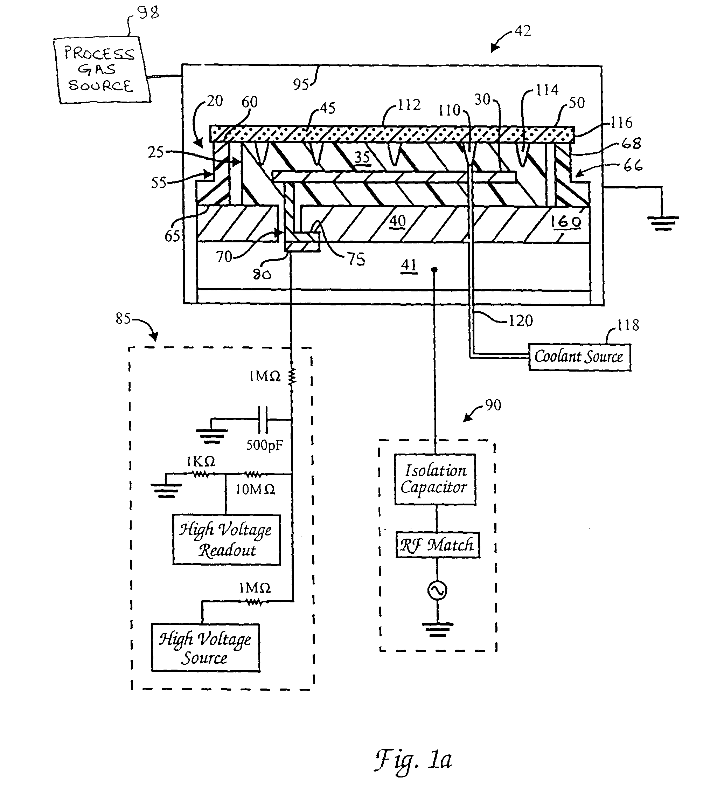

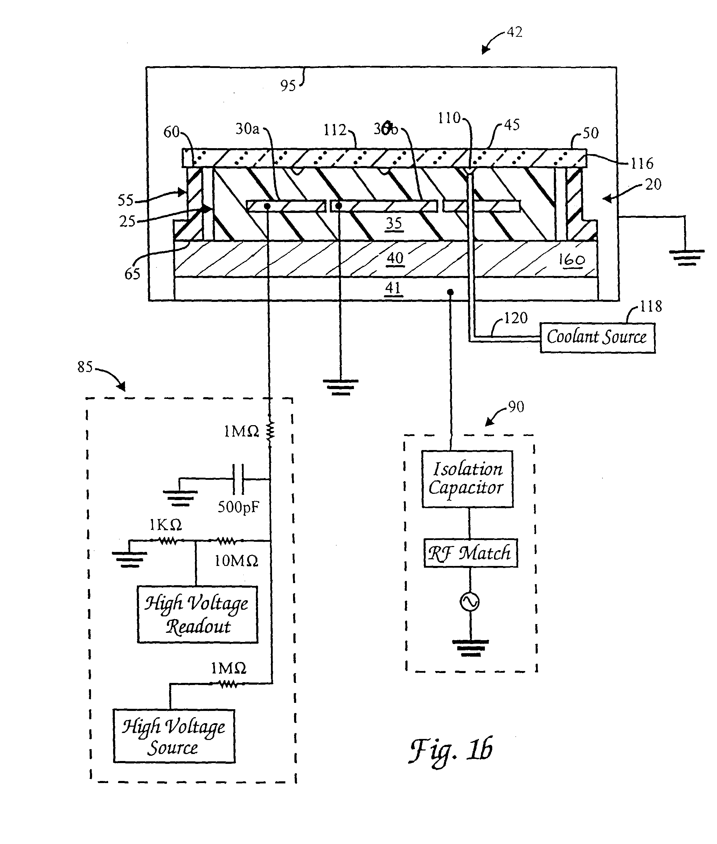

With reference to Figure 1a, an electrostatic chuck **20** according to the present invention generally comprises an electrostatic member **25** comprising an (i) an electrode **30**, and (ii) an insulator **35** covering the electrode. Typically, the electrostatic member **25** is supported on a support **40** adapted to be secured to a process electrode. commonly known as a cathode **41**, in a process chamber **42** containing an erosive process environment, for example, an oxygen plasma. A substrate **45**, such as a silicon wafer, having a peripheral edge **50** is electrostatically held on the electrostatic member **25.** A barrier **55** circumferentially disposed about the electrostatic member **25** comprises a first contact surface **60** capable of being pressed against the peripheral edge **50** of the substrate to form a seal around the substrate **45** to reduce exposure of the electrostatic member **25** to the erosive process environment. The barrier also typically includes a second contact surface **65** capable of being pressed against the support **40** so that the barrier **55** can form a seal between the substrate **45** and the support **40.** A suitable barrier **55** configuration, as shown in Figure 1a, comprises a ring **66** having a annular lip **68** capable of being resiliently pressed against the substrate **45** without dislodging the electrostatically held substrate **45**.

With reference to Figure 1a, operation of a single monopolar electrode chuck **20** in a process chamber **42** suitable for plasma processing of substrates, will now be described. The process chamber **42** is provided only to illustrate operation of the chuck **20**, and should not be used to limit the scope of the invention. The electrostatic chuck **20** is secured to the cathode **41** in the process chamber **42** using screws around the circumference of the chuck **20.** An electrical connector **70** with an electrical contact **75** is used to electrically connect the electrode **30** of the chuck **20** to a voltage supply terminal **80** on the cathode **41.** A first voltage supply **85** provides a voltage to the terminal **80** to operate the chuck **20**, and typically comprises a high voltage DC source of about 1000 to 3000 volts, connected to a high voltage readout, through a 10 MΩ resistor. A 1 MΩ resistor is provided in the circuit to limit the current flowing through the circuit, and a 500 pF capacitor is provided as an alternating current filter.

At least a portion or the cathode **41** is electrically conductive, typically aluminum, and functions as a process electrode for forming a plasma in the chamber **42**. A second voltage supply **90** is connected to the cathode **41** to electrically bias the cathode **41** with respect to an electrically grounded surface **95** in the chamber **42**. The second voltage supply **90** is conventional and typically comprises an RF impedance that matches the impedance of the process chamber **42** to the impedance of the line voltage. The RF impedance is connected in series with an isolation capacitor, as shown in Figure 1a, which serves as an alternating current filter.

During operation of the chuck **20**, a process gas from a process gas source **98** is introduced in the process chamber **42**, and the second voltage supply **90** is activated to form a plasma from the process gas introduced in the process chamber **42**. A substrate **45** is placed on the chuck **20** so that the peripheral edge **50** of the substrate contacts the first contact surface **60** of the barrier **55**. When the electrode **30** is electricaily biased with respect to the substrate **45** by the first voltage supply **85**, electrically charged plasma species impinge on the substrate **45** causing opposing electrostatic charge to accumulate in the substrate **45** and electrode **30**, resulting in an attractive electrostatic force that attracts and clamps the substrate **45** to the chuck **20**. The electrostatic attractive force conformably presses the substrate **45** against the barrier **55** forming a seal around the substrate **45** to reduce exposure of the electrostatic member **25** to the erosive gas in the process chamber **42**.

Instead of a single monopolar electrode **30**, the chuck **20** can also comprise two or more bipolar electrodes **30a**, **30b** as shown in Figure 1b, which are typically coplanar to one another and have substantially equivalent surface areas to generate substantially equivalent electrostatic attractive forces. Referring to Figure 1b, the bipolar electrodes can be powered by a single voltage supply **85** connected to one of the electrodes **30a,** with the other electrode **30b** being connected to ground (as shown). When the two electrodes **30a**, **30b** are maintained at opposing polarities, opposing electrostatic charges accumulates in the substrate **45** and electrostatically holds the substrate **45** to the chuck **20** without use of electrically charged plasma species which serve as charge carriers for electrically biasing the substrate **45**. Thus the bipolar electrode configuration is advantageous for nonplasma processes during which there are no charged plasma species. Alternatively, the voltage supply **85** can comprise two voltage sources (not shown), each of the voltage sources being separately connected to one of the electrodes **30a**, **30b**, which is useful for processes having plasma and non-plasma stages, as described in U.S. patent application no. 08/410,449, filed on March 24, 1995, entitled "Electrostatic Chuck with Improved Erosion Resistance, by Shamouiiian, et al., which is incorporated herein by reference.

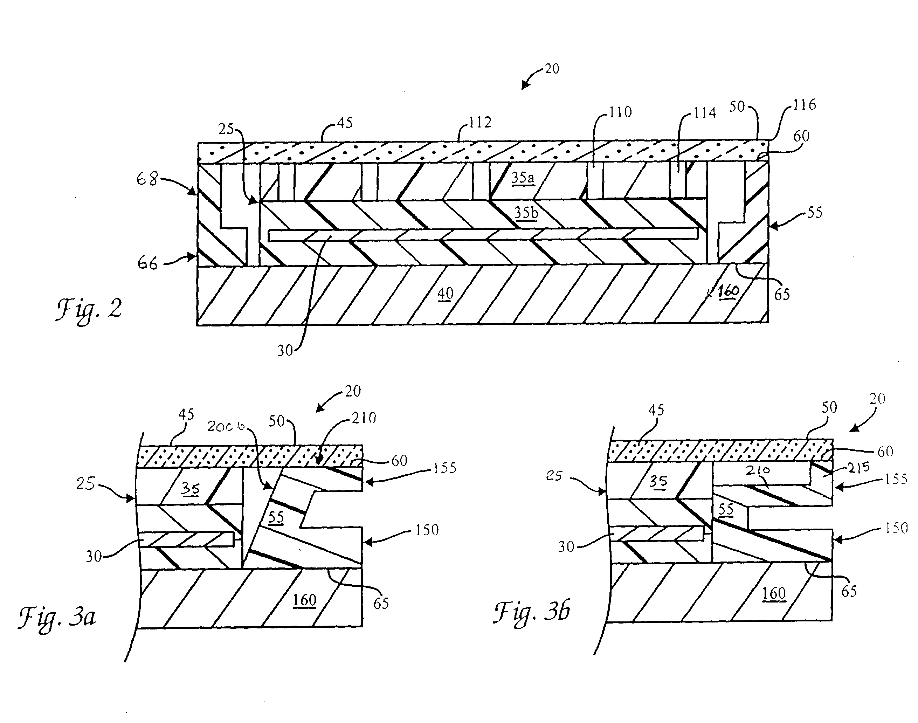

The electrostatic chuck **20** can also comprise coolant grooves **110** in the electrostatic member **25**, the grooves **110** sized and distributed to hold coolant for absorbing heat from the substrate **45** to cool the substrate **45**. Typically, the coolant grooves **45** form a pattern of radial and circumferential intersecting channels extending from below the center **112** of the substrate **45,** and having groove tips **114** positioned close to the perimeter **116** of the substrate **45,** as shown in Figure 2. Preferably, the gap between the coolant groove tips **114** and the perimeter **116** of the substrate **45** is less than about 10 mm, more preferably less than 5 mm, and most preferably less than about 3 mm, as described in aforementioned copending U.S. patent application, entitled "Corrosion Resistant Electrostatic Chuck With Improved Cooling System." When a substrate **45** is electrostatically held on the chuck **20**, the substrate **45** covers the coolant grooves **110** and seals the groove tips **114** so that coolant does not leak out from the groove tips **114.** A coolant source **118**, such as a tank of compressed helium, is used to supply coolant to the coolant grooves **110** via a supply line **120**, as shown in Figure 1a.

Preferred configurations for the barrier **55** will now be described. The barrier **55** can have any configuration or structure that has a first contact surface **60** capable of being pressed against the substrate **45** to form a seal around the substrate **45** to reduce exposure of the electrostatic member **25** to the erosive gas in the process chamber **42**. Preferably, the surface area of the first contact surface **60** of the barrier **55** is sufficiently small that the barrier **55** does not act as a thermally insulator that reduces heat flow from the substrate **45**. It has been discovered that if the area of the first contact surface **60** is too large, the barrier **55** acts as a thermal insulator and raises the temperature of the perimeter **116** of the substrate **45** at those regions close to the contact surface **65.** Thus preferably the contact area of the first contact surface **60** of the barrier **55** is sufficiently small that the barrier is substantially not thermally insulative, and allows the perimeter **116** of the substrate **45** to be maintained at temperatures less than about 100°C, and more preferably less than about 80°C. Preferably, the contact area for the first contact surface **60** of the barrier **55** is less than about 100 mm², and more typically less than about 300 mm², and often less than about 500 mm².

Preferably, the first contact surface **60** of the barrier **55** is located sufficiently close to the perimeter **116** of the substrate **45**, that when the substrate is cooled, the coolant in the grooves **110** can maintain the temperatures at the perimeter **116** of the substrate **45** substantially equivalent to the temperatures at the center **112** of the substrate **45**. By "substantially equivalent" it is meant that the difference in average temperatures of the perimeter **116** and center **112** of the substrate is less than about 10°C, more preferably less than about 7°C, and most preferably less than about 5°C. Typically, the first contact surface **60** of the barrier **55** contacts the peripheral edge **50** of the substrate **45** within about 10 mm, and more preferably 5 mm, from the perimeter **116** of the substrate **45**.

The barrier **55** can also comprise a second contact surface **65** capable of being pressed against the support **40** so that the barrier can form a seal between the substrate **45** and the support **40**. This barrier configuration facilitates quick removal and replacement of the barrier **55** which can be useful for highly erosive process environments. The area of the second contact surface **65** of the barrier **55** is sized sufficiently large to allow the barrier to securely contact and seal against the support **40**. Typically, the area of the second contact surface **65** is at least about 150 mm², and more typically from about 200 to 400 mm².

Preferably, the barrier **55** comprises a resilient structure capable of conforming and sealing the first contact surface **60** of the barrier against the peripheral edge **50** of the substrate **45** under application of an electrostatic force generated by the electrostatic member **25**, without dislodging the electrostatically held substrate **45**. For example, a suitable barrier **55** configuration, as shown in the figures, comprises a ring **66** circumferentially disposed about the electrostatic member **25** and having a annular lip **68** capable of being resiliently pressed against the electrostatically held substrate **45**. Typically, the electrostatic member **25** exerts an electrostatic attractive force per unit area (force/area) on the substrate **45** of at least about 5 Torr, and more typically from 10 to 70 Torr, and most typically from about 30 to about 50 Torr. Thus, the barrier **55** is sufficiently resilient to allow the first contact surface **60** to press against the substrate **45** with a force less than the electrostatic attractive force exerted by the electrostatic member **25** on the substrate **45**, (i) to prevent movement and dislodging of the substrate, and (ii) when necessary, to allow the substrate **45** to seal the tips **114** or the coolant grooves **110** in the electrostatic member **25** without allowing coolant to leak out from the coolant groove tips **114.**

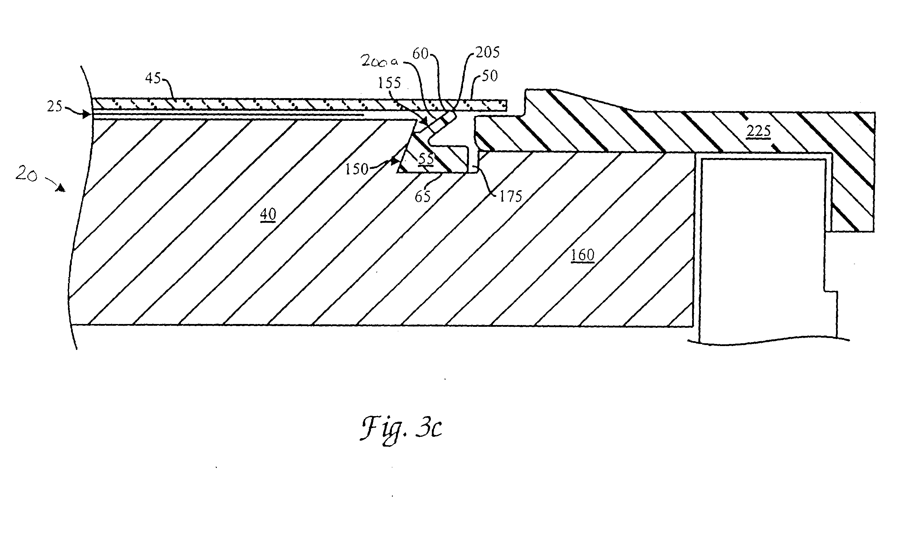

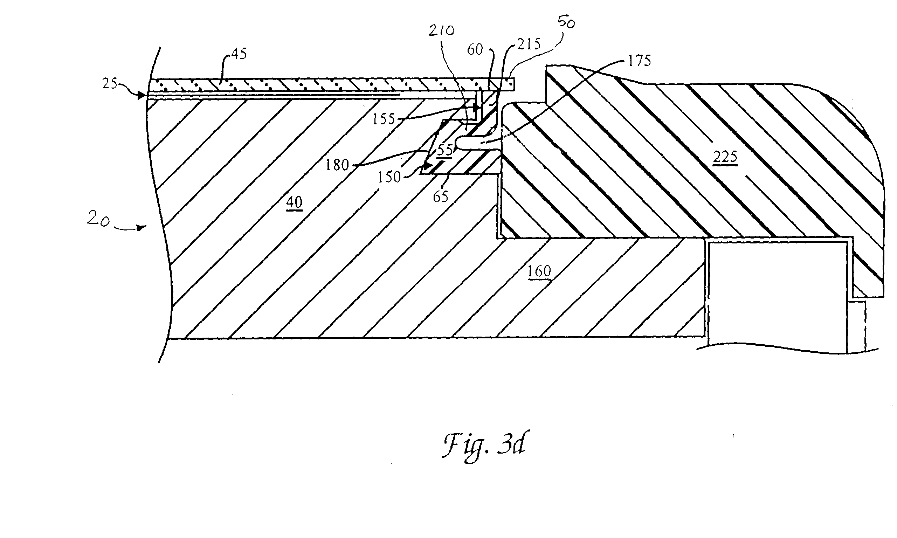

In a preferred chuck configuration **20**, the peripheral edge **50** of the substrate **45** overhangs a periphery **160** of the support **40** that extends beyond the electrostatic member **25**. The overhanging peripheral edge **50** of the substrate **45** increases the erosion resistance of the electrostatic member **25** by reducing line-of-sight impact of highly energetic plasma species (having energies in excess of 1000 eV) on the exposed sides of the electrostatic member **25.** With reference to Figure 2, a barrier **55** suitable for the preferred chuck configuration includes (i) a ring-shaped base **150** resting on the support **40,** and (ii) an arm **155** extending from the base **150** at least a portion of the arm capable of resiliently pressing against the peripheral edge **50** of the substrate **45**, as shown in Figures 2 and 3a-3d. In the configurations shown in Figures 2, 3a and 3b, the base **150** rests on the periphery **160** of the support **40** that extends below the substrate **45**. In the configurations shown in Figures 3c and 3d, the collar ledge **160** includes a channel **175** therein, and the base of the barrier **55** is sized to fit within the channel **175.** In the configuration shown in Figure 3d, the channel **175** is in a sidewall **180** of the collar ledge, and the base **150** is sized to fit in the sidewall channel **175**. It is preferred to have a channel **175** in the collar ledge **160** so that the base **150** of the barrier **55** can be securely held by the channel **175** to prevent movement or misalignment of the barrier **55** during use of the chuck **20**.

Preferably, the lip **68** or arm **155** of the barrier **55** serves as a cantilever which extends outwardly and upwardly from the ring **66** or base **150**. The cantilever configuration is advantageous because it allows the arm **155** to press against the peripheral edge **50** of the substrate **45** at a substantially small contact area of the first contact surface **60** to provide adequate sealing against the substrate **45**. For example, Figure 3c shows a cantilever configuration comprising an inclined member **200a** attached to the base **150** at one end, and having a distal end **205** which conformably presses against the substrate **45** at the first contact surface **60.** Figure 3a shows a cantilever configuration comprising a horizontal member **210** extending from an inclined member **200b**, the upper surface of the horizontal member **210** forming the first contact surface **60** conformably pressed against the substrate **45.** In Figures 3b and 3d, the cantilever arm **155** includes a substantially vertical member **215** attached to one end of the horizontal member **210**, the vertical member **215** having an edge that conformably presses against the substrate **45** forming the first contact surface **60.**

The barrier **55** of the present invention provides significantly improved erosion resistance with substantially longer chuck lifetimes. For example, where prior art chucks typically erode and fail after about 3 hours of exposure to oxygen plasmas, a chuck **20** of the present invention with a barrier **55** provided about **500** hours of erosion resistance without failure on exposure to oxygen plasma. Furthermore, the barrier **55** also substantially reduced the accumulation of polymeric reaction byproducts on the chuck **20**, when the chuck was used to hold substrates **45** in erosive process environment.

The erosion resistance of the chuck can be further increased using a circumferential collar ring **225** around the chuck **20**, as shown in Figures 3c and 3d. A masking gas assembly that directs an inert masking gas onto the periphery of the electrostatic member **25**, as described in aforementioned U.S. patent application no. 08/410,449, can also be used to enhance erosion resistance of the chuck **20**.

Methods of manufacturing the chuck **20** will now be discussed.

### Support

Generally, the support **40** used to support the electrostatic member **25** is shaped and sized according to the shape and size of the substrate **45** to maximize the heat transfer surface between the support **40** and the substrate **45**. For example, if the substrate **45** is disk shaped, a right-cylindrical support **40** is preferred. Typically, the support **40** has a central portion which receives the electrostatic member **25** and a periphery **160** which extends beyond the electrostatic member **25**. The periphery **160** of the support **40** can be shaped as a collar ledge which is at a reduced height from the central portion of the support **40** so that the support **40** resembles a pedestal. Preferably, a channel **175** is formed in the periphery **160**, or in the circumferential sidewall **180** of the periphery **160**, to hold the barrier **55**.

The support **40** is typically machined from aluminum and has a right cylindrical shape, with a diameter of about 100 to 300 mm to match the diameter of the substrate **45** which typically ranges from about 127 to about 203 mm (5 - 8 inches). and a thickness of about 1.5 to 2 cm. The top and bottom surfaces of the aluminum plate are ground using conventional aluminum grinding techniques, until the surface roughness of the plate is less than about 1 micron. Surface grinding of the plate is essential for the support **40** to uniformly contact the cathode **41** and the substrate **45** placed on the support **40**, to allow for efficient thermal transfer between the substrate **45**, the support **40**, and the cathode **41**. After grinding, the plate is thoroughly cleaned to remove grinding debris.

### Insulator

The electrostatic member **25** of the chuck **20** comprises an (i) an electrode **30**, and (ii) an insulator **35** covering the electrode. The insulator **35** typically comprises a resilient polymeric dielectric material, such as polyimide, polyketone, polyetherketone, polysulfone polycarbonate, polystyrene, nylon, polyvinylchloride, polypropylene, polyethersulfone, polyethylene terephthalate, fluoroethylene propylene copolymers, cellulose, triacetates, silicone, and rubber. When a polymer such as polyimide is used, the resilience of the polyimide, as measured by the tensile elastic modulus of the polyimide, is preferably from about 0.25 to about 10 GPa, and more preferably from about 1 to about 5 GPa. Typical polymeric insulators have (i) a dielectric constant of at least about 2, and more preferably at least about 3; (ii) a resistivity ranging from about 10¹³ Ω cm to 10²⁰ Ω cm; and (iii) a dielectric breakdown strength of at least about 100 volts/mil (3.9 volts/micron), and more typically at least about 1000 volts/mil (39 volts/micron).

The insulator **35** is sized sufficiently large to cover, and more preferably enclose the electrode **30**. The thickness of the insulator **35** required to electrically insulate the electrode **30** varies according to the electrical resistivity and dielectric constant of the polymer used to form the insulator **35.** The insulator **35** should have a sufficient thickness to conform to the substrate **45** under the electrostatic clamping force applied on the substrate **45** so that the coolant grooves **110** on the electrostatic member **25** are substantially sealed by the substrate **45**. When the polymer has a dielectric constant of about 3.5, the insulator **35** is typically about 10 µm to about 500 µm thick, and preferably from about 100 µm to about 300 µm thick.

Preferably, the polymeric insulator is resistant to temperatures in excess of 50°C, and more preferably resistant to temperatures in excess of 100°C, so that the chuck **20** can be used in processes where the substrate **45** is heated. Also, preferably, the polymeric insulator has a high thermal conductivity so that heat generated in the substrate **45** during processing can dissipate through the chuck **20.** The thermal conductivity of the insulator **35** should be at least about 0.10 Watts/m/K, to allow sufficient heat transfer to preclude overheating of the substrate **45.**

The insulator **35** can also include a high thermal conductivity filler material, such as diamond, alumina, zirconium boride, boron nitride, and aluminum nitride for increasing the thermal conductivity and resistance to plasma corrosion. Preferably, the filler material is a powder with an average particle size of less than about 10 µm. Typically, the filler is dispersed in the insulator material in a volumetric ratio from about 10% to 80%, and more typically from about 20% to 50%.

### Electrode

The electrode **30** of the electrostatic member **25** is typically made from an electrically conductive material, such as for example, metals including copper, nickel, chromium, aluminum, iron, and alloys thereof. Typically, the thickness of the electrode **30** is from about 0.5 µm to 100 µm, and more preferably the thickness is of the electrode is from about 1 µm to 50 µm, the thinner electrode providing enhanced erosion resistance for the chuck **20**. The shape of the electrode **30** varies according to the size and shape of the substrate **45**. For example, if the substrate **45** is disk shaped, the electrode **30** is also disk shaped to maximize the area of the electrode **30** in contact with the substrate **45.** Typically, the electrode **30** has an area of from about 200 to about 400 cm², and more typically from 250 to 350 cm².

The electrode **30** in the chuck **20** can have several different configurations. In one configuration, the electrode **30** is a single continuous or patterned electrode, capable of operating as a unipolar electrode **30**, as shown in Figure 1a. In another configuration the electrode **30** comprises two bipolar electrodes **30a**, **30b**, as shown in Figure 1b. Preferably, each of the bipolar electrodes **30a**, **30b** have substantially equal sizes and shapes.

Preferably, the electrode **30** is fabricated as an electrically conductive layer, such as a metal layer, embedded in an insulative layer **35** of a commercially available insulator material. As shown in Figure 2, the insulative layer **35** can comprise an upper insulator layer **35a** made of more elastic polymeric layer that allows cushioning and sealing of the coolant grooves **110**, and the lower insulator layer **35b** made of a more dielectric polymer to provide optimal electrical insolation of the electrode **30**. Preferred multilayer insulator configurations are for example described in aforementioned U.S. patent serial no. 08/369,237. Typically, the thickness of each insulator layer is from about 50 µm to about 100 µm. Suitable commercially insulative polymer films include for example, "KAPTON," a polyimide film manufactured by DuPont de Nemours Co., Wilmington, Delaware; "APIQUEO" fabricated by Kanegafuchi Chemical Indus., Japan; "UPILEX" manufactured by Ube Indus. Ltd., Japan; "NITOMID" fabricated by Nitto Electric Indus. Co. Ltd., Japan; and "SUPERIOR FILM" fabricated by Mitsubishi Plastics Indus. Ltd., Japan.

The coolant grooves **110** are cut through one or both insulative layers of the multilayer insulator by stamping, pressing, or punching the grooves through the insulator **35**. Preferably, the grooves cut through only the upper insulative layer **35a** with the tips of the grooves **114** extending close to a peripheral edge **116** of the substrate **45.** After forming the coolant grooves **110**, the multilayer insulator and electrode assembly is centered on, and adhered to the support **40** of the chuck **20**. Conventional adhesives are used to adhere the insulative layers **35a, 35b** together, the adhesives including (i) thermally activated adhesives which are non-tacky at room temperatures and tacky at elevated temperatures, or (ii) pressure sensitive adhesives which are tacky under pressure. Suitable adhesives include for example acrylics such as methacrylate, polyesters, polyamides, polyurethanes, epoxies, silicone containing adhesives, and mixtures thereof.

Methods of fabricating the insulator laminate are generally described in the U.S. patent application number 08/199,916, entitled "Electrostatic Chuck with Erosion-Resistant Electrode Connection," filed February 2, 1994 by Shamouilian, et al.

Another method for fabricating the electrostatic member 25 uses a multilayer film, comprising an insulator layer having an electrically conductive copper or aluminum layer thereon. Suitable commercially available multilayer films include for example, "R/FLEX 1100" film comprising a 25 to 125 µm thick polyimide film with a copper layer deposited thereon, from Rogers Corporation, Chandler, Arizona; Ablestik brand aluminum-filled polyimide film available from Ablestik Corporation; and Paralux® AP film, comprising polyimide directly bonded (without an adhesive) to rolled, annealed, or electrodeposited copper foil. A second insulator film is adhered over the electrically conductive layer of the multilayer film, to embed the conductive layer between two insulator films.

The electrostatic member having a patterned or segmented electrode **30** embedded in the insulator **35** is fabricated by selecting a multilayer film having an electrically conductive layer, such as the previously described "R/FLEX 1100" film, and etching, routing or milling the conductive layer to form the desired segmented electrode configuration. Conventional photolithographic and etching methods can be used to etch the electrode **30**, for example by (i) forming a patterned photoresist layer of "RISTON" fabricated by DuPont de Nemours Chemical Co. on the conductive metal layer using conventional photolithographic methods, as generally described in Silicon Processing for the VLSI Era, Volume 1: Process Technology, Chapters 12, 13, and 14, by Stanley Wolf and Richard N. Tauber, Lattice Press, California (1986), which is incorporated herein by reference, and (ii) etching the exposed portions of the conductive layer using conventional wet or plasma etching techniques. In a typical wet chemical etching method the multilayer film is immersed in an etchant such as ferric chloride, sodium persulfate, or into an acid or base. A typical plasma etching processes uses a plasma of chlorine, oxygen, or SiCl₄, to etch the conductive layer, as generally described in VLSI Technology, Second Edition, Chapter 5, by S.M. Sze, McGraw-Hill Publishing Company (1988), which is incorporated herein by reference. Residual photoresist can be removed using a conventional acid or oxygen plasma stripping process. After etching, a second insulator film is adhered over the patterned electrode **30** to embed the electrode **30** within the insulator **35**, as described above.

### Electrical Connector

The electrostatic member **25** is connected to the terminal **80** via an electrical connector **70**. Preferably, the electrical connector **70** extends through the support **40**, rather than around the edge of the support **40**, so that during processing the substrate **45** covers the electrical connector **70** and reduces exposure of the connector **70** to the erosive process gases in the chamber **42**. Preferred electrical connectors **60** are described in aforementioned U.S. patent application no. 08/410,449.

### Barrier

Preferably, at least a portion of the barrier **55** is fabricated from a resilient polymer that is substantially resistant to chemical degradation and erosion by the erosive process gas. Suitable polymers include for example, polyethylene, polyurethane, polycarbonate, polystyrene, nylon, polypropylene, polyvinylchloride, polyethylene terephthalate, fluoroethylene propylene copolymers, and silicone.

Preferred resilient polymers include elastomers, such as for example, natural rubber (with an elastic modulus of 2500 psi), "SBR" (2500 psi), acrylate, butyl (1000 psi), chlorosulfonated polyethylene, "EPDM", epichlorohydrin, fluorinated rubbers (250 psi), neoprene (1000 psi), nitrile (1500 psi), polybutadiene, polyisoprene (2500 psi), polysulfide (1400 psi), silicone, and urethane (1200 psi). The reported modulus values which range from 250 to 2500 psi, and more typically 1000 to 2000 psi, were measured at 300-400% elongation. Elastomers are generally described in Textbook of Polymer Science, Third Edition, Fred W. Billmeyer, John Wiley & Sons, New York, 1984, which incorporated herein by reference. Preferred commercially available erosion resistant elastomers include halogenated elastomers, such as "VITON," a fluorine containing elastomer and "CHEMRAZ-570" perfluoroelastomers, both commercially available from Greene Tweed, Culpsville, Pennsylvania. Alternative materials include "TEFLON," a fluoropolymer commercially available from Dupont de Nemours, Wilmington, Delaware. The barrier **55** can be fabricated using conventional injection molding or casting methods.

### Operation of the Chuck

Referring to Figure 1a, typical operation of the chuck **20** for holding a substrate **45** in a process chamber **42** is now described. To effect the process, the process chamber **42** is evacuated to a pressure ranging from about 1 to about 500 mTorr, and more typically from about 10 to about 100 mTorr. A semiconductor substrate **45**, such as a silicon wafer, is transferred to the chamber **42** from a load lock transfer chamber (not shown), and placed on the electrostatic member **25** of the chuck **20** in the chamber **42**. Process gas is introduced in the process chamber **42,** the type of process gas varying according to whether the substrate **45** is etched or whether material is deposited on the substrate **45**. Conventional etchant gases include for example, Cl₂, BCl₃, CCl₄, SiCl₄, CF₄, NF₂, and mixtures thereof, as described in S. Wolf and R. N. Tauber, Silicon Processing for the VLSI Era, Vol. I, Chap. 16: Dry Etching for VLSI, Lattice Press, Sunset Beach, California (1986), which is incorporated herein by reference.

The second voltage supply **90** is then activated to electrically bias the cathode **41** with respect to the grounded surface **95** in the chamber **42** to form a plasma from the process gas for etching the substrate **45**. Activating the first voltage supply **85** applies a sufficient voltage to the electrode **30** in the electrostatic member **25** to electrical bias the electrode **30** with respect to the substrate **45** to generate a sufficient electrostatic force to attract holds the substrate **45** to the chuck **20**, pressing the peripheral edge **116** of the substrate **45** against the first contact surface **60** of the barrier **55** to form a seal between the substrate **45** and the support **40** to protect the electrostatic member **25** from exposure to the erosive environment in the chamber **42.**

During the process, the coolant source **118** provides the coolant, typically helium, to the coolant grooves **110** in the electrostatic member **25**. The flow of the coolant beneath the substrate **45** removes heat from the substrate **45** to maintain substantially uniform temperatures across the substrate **45** during its processing.

Electrostatic chucks having features of the present invention have several advantages. The barrier **55** enhances the erosion resistance of the chuck **20**, by protecting the electrostatic member **25** of the chuck **20** from exposure to the erosive process gases in the process chamber **42**, thereby significantly improving the useful lifetime of the chuck **20** in erosive environments. Further, the barrier **55** substantially reduces accumulation of polymeric reaction byproducts on the chuck **20**, when the chuck was used to hold substrates **45** in erosive processes. Also, the barrier **55** allows uniform cooling of the substrate **45**.

While the present invention has been described in considerable detail with reference to certain preferred versions, many other versions should be apparent to those skilled in the art. For example, although illustrative barrier configuration **55** as are described herein, the barrier **55** can comprise any resilient structure that would be apparent to one of ordinary skill in the art, such as for example, a rubber ring seal. Therefore, the spirit and scope of the appended claims should not be limited to the description of the preferred versions contained herein.

## Claims

1. A method of enhancing the erosion resistant of an electrostatic chuck in an erosive environment, the chuck comprising (i) a electrostatic member capable of electrostatically holding a substrate, and (ii) a support for supporting the electrostatic member, the method comprising the steps of:
(a) positioning a barrier on the support so that the barrier is circumferentially disposed about the electrostatic member, the barrier comprising a contact surface capable of being pressed against a substrate;
(b) placing a substrate on the electrostatic member so that a peripheral edge of the substrate contacts the contact surface of the barrier; and
(c) applying a voltage to the electrostatic member to electrostatically attract the substrate with sufficient electrostatic force that the peripheral edge of the substrate presses against the contact surface of the barrier forming a seal between the substrate and the support to reduce exposure of the electrostatic member to the erosive environment.

2. The method of claim 1, wherein the barrier comprises a resilient structure capable of pressing the first contact surface against the electrostatically held substrate without dislodging the substrate.

3. The method of claim 2, wherein the barrier comprises a ring having a annular lip capable of being resiliently pressed against the substrate.

4. The method of claim 3, wherein step (c) comprises applying a voltage to the electrostatic member to electrostatically attract the substrate with sufficient electrostatic force to cause the annular lip to resiliently and conformably seal against the substrate.

5. The method of claim 3, wherein the electrostatic member further comprises coolant grooves for holding coolant below the substrate, the coolant grooves having tips close to the peripheral edge of the substrate, and
wherein step (c) comprises applying a voltage to the electrostatic member to electrostatically attract the substrate with sufficient electrostatic force to cause the annular lip to resiliently and conformably seal against the substrate substantially without causing leaking of coolant from the coolant grooves tips.

6. The method of claim 1, wherein in step (c) a sufficient voltage is applied to the electrostatic member to attract the substrate with an electrostatic force/area of at least about 5 Torr.

7. The method or claim 1, wherein the substrate comprises a center and a perimeter, and wherein the contact surface of the barrier has a sufficiently small contact area located sutficiently close to the perimeter of the substrate that when the substrate is heated, the difference in temperatures between the center and perimeter of the substrate is less than about 10°C.

8. The method of claim 7, wherein the contact area of the contact surface of the barrier is less than about 100 mm².

9. The method of claim 7, wherein substantially the entire contact surface of the barrier contacts the substrate within about 10 mm from the perimeter of the substrate.

10. The method of claim 1, wherein a periphery of the support extends below the peripheral edge of the substrate, and wherein the barrier comprises a (i) a base, and (ii) an arm extending from the base, and wherein step (a) comprises positioning the base of the barrier on the support with the arm of the barrier extending toward the substrate.

11. The method of claim 10, wherein the support comprises a peripheral sidewall having a channel therein, and wherein step (a) comprises positioning the base of the barrier in the channel in the support, with the arm of the barrier extending toward the substrate.

12. The method of claim 1, wherein the barrier comprises a resilient and pliant material capable of conforming and forming a seal between the substrate and support.

13. The method of claim 12, wherein the barrier is made from an elastomer that is substantially resistant to erosion by the erosive process gas.

14. The method of claim 13, wherein the barrier is made from a halogenated elastomer.
